# EUROPEAN PATENT SPECIFICATION

(11) **EP 1 231 031 B1**
(45) Date of publication and mention of the grant of the patent: **11.10.2006**
(21) Application number: 00970224.2
(22) Date of filing: 30.10.2000
(51) Int. Cl.: B25J 15/06, H05K 13/04

(54) **SUCKING NOZZLE AND METHOD AND DEVICE FOR INSTALLING PARTS USING THE NOZZLE**
SAUGDÜSE UND VERFAHREN UND VORRICHTUNG ZUM INSTALLIEREN VON WERKSTÜCKEN MIT DIESER DÜSE
BUSE D'ASPIRATION ET METHODE ET APPAREIL PERMETTANT D'INSTALLER DES PIECES AU MOYEN DE CELLE-CI

(30) Priority: 29.10.1999 JP 30916399
(43) Date of publication of application: 14.08.2002
(73) Proprietor: MATSUSHITA ELECTRIC INDUSTRIAL CO., LTD., Kadoma-shi, Osaka 571-8501 (JP)
(72) Inventor: HATA, Kanji Matsushita Electric Industrial Co.,Ltd, Osaka 571-8501 (JP); OJI, Shiro Matsushita Electric Industrial Co., Ltd, Osaka 571-8501 (JP); KOSAKA, Kazuaki Matsushita Electric Industr.Co.Ltd, Osaka 571-8501 (JP); MORIMOTO, Masahiro Matsushita Elect.Indust.Co. Ltd, Osaka 571-8501 (JP)
(74) Representative: Rackham, Stephen Neil
(86) International application number: PCT/JP2000/007647
(87) International publication number: WO 2001/030543

(56) References cited:
- EP-A- 0 793 409
- WO-A-97/31516
- WO-A-98/33369
- JP-A- 9 270 595
- JP-A- 9 293 770
- JP-A- 10 075 095
- JP-A- 11 103 197

## Description

The present invention relates to a component mounting method and apparatus for mounting an electronic component on a substrate.

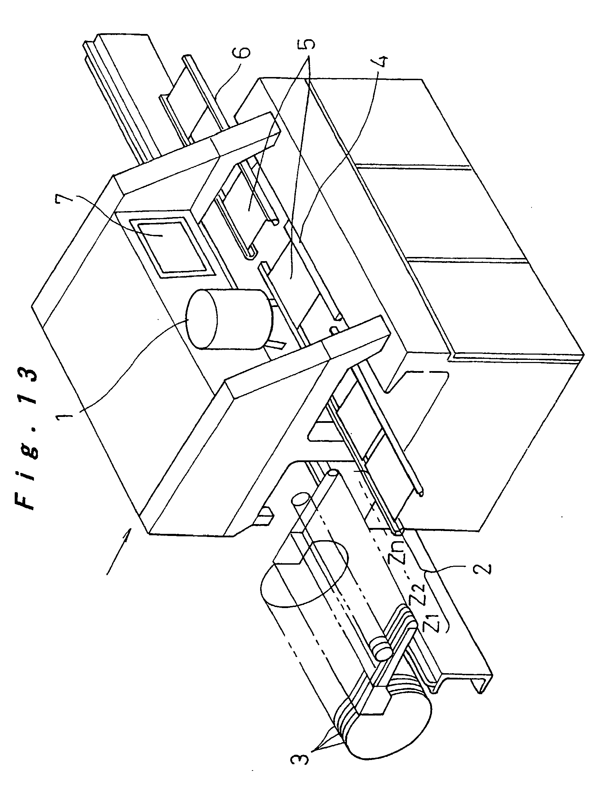

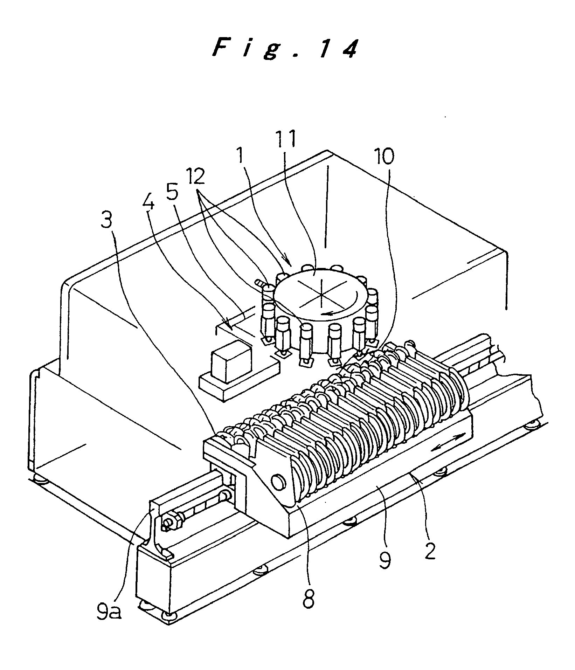

As an example of electronic component mounting apparatuses for mounting an electronic component on a circuit board, a rotary head type apparatus is known. An apparatus of this type is capable of performing mounting at high speed, and thus has been in wide use as main equipment for manufacturing an electronic circuit board. Fig. 13 shows a conventional electronic component mounting equipment, and Fig. 14 shows a structure of a principal portion of a rotary head type electronic component mounting apparatus. A mounting portion 1 is configured to pick up a component from any of component supply means 3 provided in a component supply portion 2, and mount the component on a substrate 5 set on an 25 *X-Y* table 4.

In the component supply portion 2, a multiplicity of component supply means 3 are mounted on a component supply table 9. Each of the component supply means 3 has a component reel 8 set therein. Wound on the reel is a tape accommodating a multiplicity of components of predetermined kinds. The component supply table 9 having the component supply means 3 mounted thereon is moved along a guide rail 9a, so that any given component supply means 3 is set in a predetermined component supply position 10. The mounting portion 1 is composed of a rotary table 11 which is rotated intermittently. At the outer periphery of the rotary table are provided a plurality of mounting heads 12. Each of the mounting heads 12 is provided with a single or a plurality of suction nozzles. Upon reaching the component supply position 10, the mounting head picks up a component from the component supply means 3 by way of the suction nozzle. Then, by the rotation of the rotary table 11, the mounting head 12 is stopped at a component mounting position. At this instant, the component suckingly held is mounted on the substrate 5 positioned by the X-Y table 4. By repeating this operation, the components fed from the component supply portion 2 are successively mounted on the substrate 5, thereby producing a circuit board.

Since various kinds of components are mounted on the substrate 5, in order to deal with components of varying shapes and sizes, the mounting head 12 is provided with a plurality of suction nozzles of various types. These suction nozzles are made selectable according to the types of component to be suckingly held.

In recent years, higher and higher speed has been sought after in component mounting, and this trend has created an increasing demand for the reduction of time taken to move each constituent mobile member. However, while it is relatively easy to reduce the amount of time for moving the mounting head 12 by increasing the rotational speed of the rotary table 11 in the mounting portion 1, it is difficult to reduce the amount of time for moving the component supply table 9 and the X-Y table 4. This is because the limitation imposed on the time available for the movement of the latter is severer than that on the time for the movement of the former. To solve the above-mentioned problem, the inventors of the present application came up with a component mounting method and apparatus capable of mounting components at higher speed by shortening the distance of movement of the component supply table 9 and the X-Y table 4. This component mounting method and apparatus is proposed in Japanese Patent Application No. Hei. 10-303562.

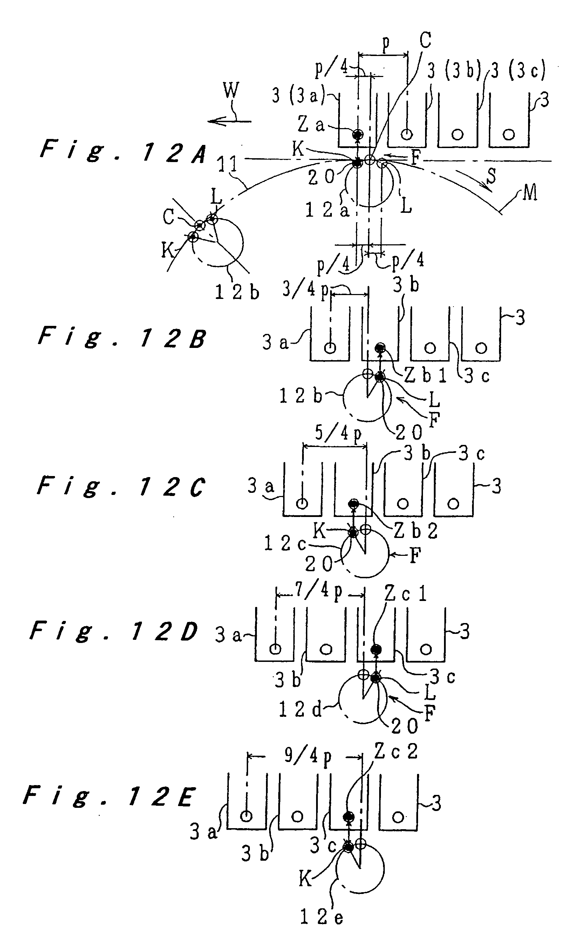

Figs. 12A through 12E respectively show the working of the above-mentioned component mounting apparatus devised by the inventors. In these figures, the rotary table 11 of the mounting portion 1 is rotated intermittently, so that each of the mounting heads 12 provided at the outer periphery of the rotary table 11 sucks components successively from the component supply means 3. In Fig. 12A, one mounting head 12a included in the mounting heads 12 sucks a component, and, in Fig. 12B, another mounting head 12b sucks a component upon completion of the one-pitch intermittent rotation of the rotary table 11. Subsequently, as seen from Figs. 12C, 12D, and 12E, mounting heads 12c, 12d, and 12e suck components successively.

As shown in Figs. 12A through 12E, in a state where the mounting heads 12a to 12e are respectively stopped at a component supply position F indicated by an arrow, a suction nozzle 20 is selectively set in either a first sucking position K or a second sucking position L. The first sucking position K is deviated upstream from a reference point C, at which a rotation circle M of the rotary table 11 is tangent to a movement-direction line W of the component supply means 3, along a rotation direction S of the rotary table 11. The second sucking position L is deviated downstream from the reference point C along the rotation direction S of the rotary table 11. According to this method, the amount of movement of the component supply means 3 is reduced to half, thereby significantly reducing the cycle time required for mounting components.

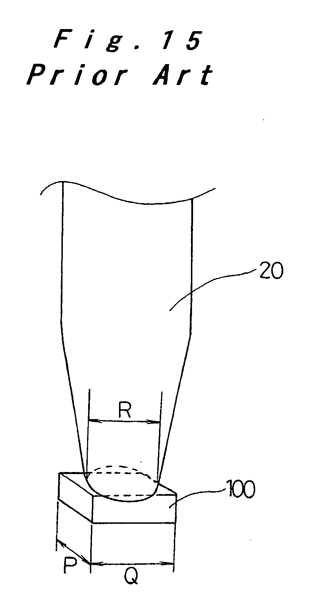

However, when a component is sucked at the first sucking position K deviated upstream from the reference point C along the rotation direction S of the rotary table 11, or at the second sucking position L deviated downstream, the suction nozzle 20 tends to be positionally deviated with respect to the predetermined position and posture of the component fed from the component supply means 3. This positional deviation, though being a minor error, may cause various problems in fine components. For example, there exists a fine-size chip component which is 0.6 mm in longer side and 0.3 mm in shorter side. To deal with such a fine component, the pitch with which a tape is carried to supply a component, or the interval between adjacent components when mounted on a substrate is minimized. Hence, as shown in Fig. 15, in order for a so-called 0603 chip component 100 as mentioned just above to be sucked by the conventional suction nozzle 20 having a circular tip, to prevent the suction nozzle from interfering with adjacent components, a diameter R of the tip of the nozzle needs to be made larger than a shorter side P of the component but smaller than a longer side Q thereof, specifically, needs to be set at as small as ca. 0.5 mm. This leads to a poor durability and thus to shortening of the service life. What is worse, the component can be damaged by an impact produced when it is brought into abutment with the suction nozzle 20 having a fine tip. Further, since the fine suction nozzle 20 is positioned with respect to the fine component, even a slight positional deviation causes a suction error. This leads to an undesirable reduction in the suction rate.

An object of the present invention is to provide a suction nozzle that is designed to deal with a fine component and nevertheless has a long service life and a satisfactory suction rate, and also provide a component mounting method and apparatus employing the suction nozzle.

According to a first aspect of the invention, there is provided a component mounting method comprising:
successively feeding a plurality of components, each having a surface to be sucked, from a component supply portion to a predetermined position, the components being arranged in juxtaposition in a minor-axis direction thereof; and
suckingly holding and mounting on a substrate the components by a suction nozzle, the suction nozzle having a sucking surface,
wherein the components are sucked at the predetermined position by the suction nozzle, by the sucking surface abutting on the surface to be sucked, to mount the sucked components on the substrate,
characterised by:
the surface to be sucked of each of the components being rectangular and including a longer side and a shorter side;
a longitudinal axis of the sucking surface being kept inclined with respect to a direction in which the components are supplied during the holding and mounting of the components; and
the sucking surface being made larger in area than the surface to be sucked, and being configured arbitrarily so long as a width between mutually-opposed sides, which are parallel to the longer side of the component and are inclined with respect to the longitudinal axis of the sucking surface, is smaller than a width parallel to the longer side of the component to be sucked.

In this construction, because the sucking surface of the nozzle is made larger in area than the surface to be sucked of the component, the durability of the nozzle is enhanced, despite the nozzle being designed to deal with a fine component. Moreover, the nozzle may have a slim tip so as to be capable of dealing with a multiplicity of components that are arranged in a row with their minor-axis direction sides, i.e. longer sides, kept parallel to one another, without interfering with adjacent components during sucking a component and interfering with already-mounted components during mounting the component on a substrate. When the suction nozzle sucks a component, with a shaft of its sucking surface rotated at a certain angle with respect to the component, if the component has a fine size, the suction nozzle is inconveniently deviated from the component. This leads to a suction error. However, in the suction nozzle of the present invention, the sucking surface is made sufficiently large and the nozzle opening is made larger in area, and accordingly a strong suction force is obtained. This makes it possible to increase allowance for the positional deviation between the nozzle and components, thereby preventing degradation in the suction rate even in fine components.

In the above-described construction, the sucking surface may have in its central part a nozzle opening which is formed in conformity with the shape of the surface to be sucked. Since the nozzle opening is formed in the sucking surface which is made larger in area than the surface to be sucked of the component, a sufficiently large opening area is secured, thereby increasing the suction force. Consequently, even if the suction nozzle has a small size, components are suckingly held with high suction rate.

Further, in the component supply portion, the components, arranged in juxtaposition, preferably with their longer sides kept parallel to one another, are fed to a predetermined position one after another. At this time, since the sucking surface is so formed that its width parallel to the longer side of the component is made small, during the time that the components arranged in juxtaposition with their longer sides kept parallel to one another are being sucked, no interference occurs with adjacent components.

According to a second aspect of the invention, there is provided a component mounting apparatus comprising:
a component supply portion for successively feeding a plurality of components, each having a surface to be sucked, to a supply position, the components being arranged in juxtaposition in a minor-axis direction thereof;
a suction nozzle having a sucking surface for sucking the component by abutting on the surface to be sucked; and
component mounting means for sucking the component at the supply position by way of the suction nozzle and for mounting the sucked component on a substrate by moving the suction nozzle,
characterised by:
the surface to be sucked of each of the components being rectangular and including a longer side and a shorter side; and
the sucking surface being made larger in area than the surface to be sucked, and being configured arbitrarily so long as a width between mutually-opposed sides, which are parallel to the longer side of the component and are inclined with respect to a longitudinal axis of the sucking surface, is smaller than a width parallel to the longer side of the component.

The sucking surface may have in its central part a nozzle opening which is formed in conformity with a shape of the surface to be sucked.

In the constructions described thus far, the sucking surface may be formed so as to have a polygonal configuration including mutually-opposed sides parallel to the longitudinal direction of the component. This allows the suction nozzle to suck a component without interfering with the other components arranged in juxtaposition and to mount the component on a substrate without interfering with the already-mounted components. Thus, the suction nozzle is suited for a substrate having a high packaging density. Alternatively, the sucking surface may be formed so as to have a hexagonal configuration like a tortoiseshell pattern including mutually-opposed sides parallel to the longitudinal direction of a component. Further, even if the sucking surface is formed in the shape of an oval or an elongated ellipse, the corresponding effect is obtained.

Still further, by providing the nozzle opening with a narrowed portion whose opening diameter is made shorter than the dimension of the shorter side of the surface to be sucked of the component, it is possible to prevent the component from being sucked into the nozzle opening or being sucked in a stand-up or slanted state.

In the method according to a preferred embodiment, the components arranged in juxtaposition with their longer sides kept parallel to one another are sucked by the suction nozzle having the sucking surface designed so that the width in a direction parallel to the longer side of the component is made smaller. This allows the suction nozzle to suck a component without interfering with the other components arranged in juxtaposition and to mount the component on a substrate without interfering with the already-mounted components.

In the apparatus according to a preferred embodiment, the components arranged in juxtaposition with their longer sides kept parallel to one another are sucked by the suction nozzle having the sucking surface designed so that the width in a direction parallel to the longer side of the component is made smaller. This allows the suction nozzle to suck a component without interfering with the other components arranged in juxtaposition and to mount the component on a substrate without interfering with the already-mounted components. Consequently, a component mounting apparatus is provided that suffers less from a suction error and is thus applicable to high-density mounting.

Consequently, a component mounting apparatus and method is provided that suffers less from a suction error and is thus applicable to high-density mounting.
Figs. 1A and 1B show the structure of a suction nozzle according to an embodiment of the present invention, with Fig. 1A being a sectional view, and Fig. 1B being a plan view as seen on the front-end side of the structure;
Fig. 2 is a plan view showing the structure of a sucking surface of the suction nozzle;
Figs. 3A and 3B are views illustrating an angle at which a component is sucked by the suction nozzle, with Fig. 3A showing the position of the nozzle at the first sucking position, and Fig. 38 showing the position of the nozzle at the second sucking position;
Fig. 4 is a view illustrating how a component is sucked at the first sucking position;
Fig. 5 is a view illustrating how a component is sucked at the second sucking position;
Fig. 6 is a plan view showing another configuration of the sucking surface of the suction nozzle;
Fig. 7 is a plan view showing still another configuration of the sucking surface of the suction nozzle;
Fig. 8 is a plan view showing a state in which a component sucked by the suction nozzle is mounted on a substrate;
Fig. 9 is a view illustrating how a component is sucked at the reference point;
Fig. 10 is a sectional view showing an example of the structure of a mounting head;
Fig. 11 is a schematic view showing a plane-wise arrangement as observed in a component mounting apparatus;
Figs. 12A to 12E are views illustrating a component mounting method step by step;
Fig. 13 is a perspective view showing the entire structure of the component mounting apparatus;
Fig. 14 is a perspective view showing the structure of the principal portion of the component mounting apparatus; and
Fig. 15 is a view illustrating how a component is sucked by a conventional suction nozzle.

Hereinafter, an embodiment of the present invention will be described with reference to the accompanying drawings.

First, a description will be given as to the structure and operation of a component mounting apparatus to which a suction nozzle of the embodiment is applied. The structure and operation of this component mounting apparatus is proposed in Japanese Patent Application No. Hei. 10-303562 by the inventors of the present application. The entire structure of the component mounting apparatus is shown in Figs. 13 and 14. As has already been explained in the description of the conventional art, the component mounting apparatus is constructed as follows. In a mounting portion 1, a component is picked up from any of component supply means 3 of a component supply portion 2, and is then mounted on a substrate 5 set on an X-Y table 4.

Each of the component supply means 3 mounted on the component supply portion 2 is constructed as a parts cassette having mounted therein a taping component formed by winding on a reel a tape accommodating components arranged equidistantly in its extending direction. The component supply means 3 serves to supply components successively at its end portion. A multiplicity of the component supply means 3, each accommodating a component of predetermined kind, are mounted on a component supply table 9. The component supply table 9 is moved along a guide rail 9a so as for any of component supply means 3 to be set in a component supply position 10, thereby feeding a given component to the component supply position 10.

The mounting portion 1 is composed of a rotary table 11 which is rotated intermittently. At the outer periphery of the rotary table are provided a plurality of mounting heads 12. As the rotary table 11 is rotated intermittently, the mounting head 12 reaches the component supply position 10 to suck up a component from the component supply means 3 by way of a suction nozzle. Then, by the further intermittent rotation of the rotary table, the mounting head 12 is stopped at a component mounting position. Thereupon, the component is mounted at a predetermined position on the substrate 5 positioned by the X-Y table 4. The mounting head 12 is provided with a plurality of suction nozzles that are selectable according to the type of a component to be held.

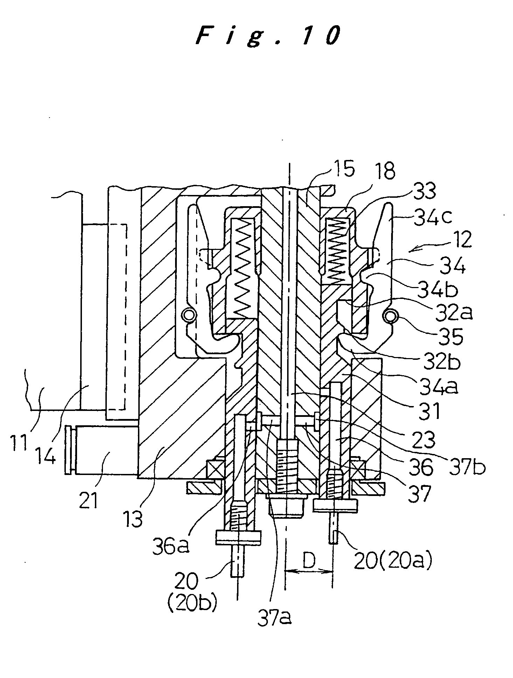

Fig. 10 shows an example of the structure of the mounting head 12. The mounting heads 12, plurally disposed about the periphery of the rotary table 11, are each provided with a plurality of suction nozzles 20 of various kinds that are disposed on an outer periphery of a rotary body 18, fixed to a lower end of a rotary shaft 15, in such a way as to be parallel to a rotation axial center thereof. The suction nozzles 20 are each fitted to a lower end of a movable shaft 31 that is supported on the outer periphery of the rotary body 18 so as to be movable in upward and downward directions. The movable shaft 31 has in its upper part positioning stepped portions 32a and 32b so as to be held at descending and ascending positions. Moreover, between the upper end of the movable shaft 31 and the rotary body 18 is interposed a spring 33 which exerts an urging force in a downward direction. At the outer periphery of the rotary body 18 is disposed a retaining pawl 34 which is made oscillatable between an engagement position and a disengagement position with respect to the positioning stepped portion 32a, in correspondence with each of the movable shafts 31. Around the pawl 34 is externally fitted a ring spring 35 which exerts an urging force toward the engagement position. The retaining pawl 34 has at its lower end an engagement portion 34a corresponding to the positioning stepped portions 32a and 32b, has at its midpoint position a fulcrum protrusion 34b, and has at its upper end an oscillation operation portion 34c. In Fig. 10, while a suction nozzle 20a shown in the right-hand part of the figure is kept in the ascending position, the engagement portion 34a of the retaining pawl 34 is engaged with the positioning stepped portion 32b, so that the movable shaft 31 is held in the ascending position against the urging force of the spring 33. In this state, by pressing the oscillation operation portion 34c, the retaining pawl 34 is shifted to the disengagement position; the movable shaft 31 is shifted to the descending position; and the engagement portion 34a is engaged with the positioning stepped portion 32a. Consequently, as seen from the left-hand part of Fig. 10, a suction nozzle 20b is held in the descending position.

In the lower part of the movable shaft 31 is formed an air passageway 36 communicating with the suction nozzle 20. Inside the rotary shaft 15 is formed an air passageway 23. The air passageway 23 has in its lower part an air passageway 37 composed of a radial groove 37a and an outer-peripheral annular groove 37b. The air passageway 36 of the movable shaft 31 includes a communication path 36a facing toward the rotary shaft 15. In this arrangement, when any given movable shaft 31 is held in the descending position, the air passageway 36 of the movable shaft 31 and the air passageway 37, 23 of the rotary shaft 15 are allowed to communicate with each other by the annular groove 37b and the communication path 36a. Thereby, the suction nozzle 20 is allowed to suck a component when the movable shaft 31 is located in the descending position by pressing the oscillation operation portion 34c of the retaining pawl 34. Accordingly, by operating the retaining pawl 34 corresponding to the suction nozzle suitably selected according to the kinds of components, the suction nozzle 20 is moved downward and brought into an operable state. In this state, by rotating the rotary body 18, it is possible to select the operation position of the suction nozzle 20, thereby performing sucking and mounting operations of the components.

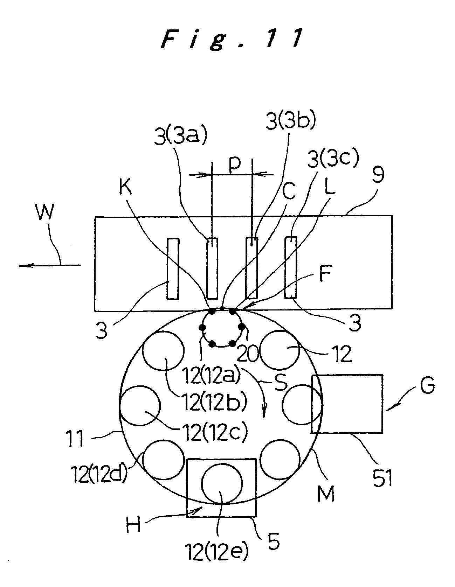

With reference to Figs. 11, and 12A through 12E, a description will be given as to the component mounting operation conducted by the component mounting apparatus having the above-described structure. Fig. 11 shows the plane-wise arrangement of the portions constituting the component mounting apparatus.

In Fig. 11, on the one hand, the rotary table 11 having a plurality of the mounting heads 12 disposed thereon, which is rotated intermittently in one direction S, is driven to stop at the component supply position F successively. On the other hand, out of a multiplicity of the component supply means 3 mounted in juxtaposition on the component supply table 9 which is moved in a direction of a tangent W to the rotation circle M of the rotary table 11, the component supply means 3 for supplying to-be-sucked components are driven to stop at a predetermined position successively. The mounting head 12 located at the component supply position F sucks a component fed from the component supply means 3 by way of the suction nozzle 20. When the mounting head 12 reaches a component recognition position G upon the intermittent rotation of the rotary table 11, the sucked component is recognized by a component recognizing camera 51, and further, on reaching a component mounting position H, the sucked component is mounted on the substrate 5.

As shown in Fig. 10, the mounting head 12 is so designed that the rotation axial center of the rotary shaft 15 and the axial center of the suction nozzle 20 are deviated by an amount of D. In the state where the mounting head 12 is stopped at the component supply position F, the suction nozzle 20 located at the descending position is selectively set in either a first sucking position K or a second sucking position L. The first sucking position K is deviated upstream from a reference point C, at which the rotation circle M of the rotary table 11 is tangent to a movement-direction line W of the component supply means 3, along the rotation direction S of the rotary table 11. The second sucking position L is deviated downstream from the reference point C along the rotation direction S of the rotary table 11 (refer to Fig. 11).

On the component supply table 9 are juxtaposed the component supply means 3 at intervals p. The component supply table 9 is intermittently moved with a pitch p/2 in the W direction indicated by an arrow in Fig. 11. Moreover, the amount of deviation of the first and second sucking positions K and L from the reference point C is set at p/4. Hereinafter, with reference to Figs. 12A through 12E, the details of the component sucking operation will be described.

In the first cycle as shown in Fig. 12A, the mounting head 12a located at the component supply position F is driven to select the first sucking position K as the position of the suction nozzle 20, and then sucks a component Za fed from the component supply means 3a positioned correspondingly. In the second cycle as shown in Fig. 12B, the following mounting head 12b having reached the component supply position F is driven to select the second sucking position L as the position of the suction nozzle 20, and then sucks a component Zb1 fed from the following component supply means 3b set in the corresponding position after being pitch-shifted by an amount of p/2. In the third cycle as shown in Fig. 12C, the third mounting head 12c having reached the component supply position F is driven to select the first sucking position K as the position of the suction nozzle 20, and subsequently sucks a component Zb2 fed from the same component supply means 3b as used in the second cycle, which is set in the corresponding position after being pitch-shifted by an amount of p/2. In the fourth cycle as shown in Fig. 12D, the fourth mounting head 12d having reached the component supply position F is driven to select the second sucking position L as the position of the suction nozzle 20, and then sucks a component Zc1 fed from the third component supply means 3c set in the corresponding position after being pitch-shifted by an amount of p/2. Next, as shown in Fig. 12E, the mounting head 12e having reached the component supply position F, as in the case of the first cycle, sucks a component Zc2 fed from the third component supply means 3c. By repeating these process steps, the component sucking operation is performed.

Note that, to repeat the component sucking operation in any of the first to fourth cycles with the component supply table 9 kept at rest without carrying out pitch-shifting, the mounting head 12 coming to the component supply position F next is driven to select the same sucking position as selected by the preceding mounting head 12, so as to suck the component fed from the identical component supply means 3. For example, to allow the mounting head to suck the component fed from the component supply means 3a once again in the state shown in Fig. 12A, the succeeding mounting head 12b is driven to select the first sucking position K. Hereupon, the component sucking operation is performed.

According to the operation described above, components are successively picked up while the component supply table 9 is being moved in the W direction continuously, and, at the time of picking up components successively from the identical component supply means 3, the first mounting head 12 is driven to select the sucking position K, and the last mounting head 12 is driven to select the sucking position L. In this manner, the amount of movement of the component supply means 3 per cycle is reduced to half of the pitch p (p/2) between the adjacent component supply means 3. Commonly, a multiplicity of component supply means 3 are mounted on the component supply table 9. Thus, reduction in the amount of movement of the component supply table 9 per cycle is the key to reduce the cycle time required for mounting components. In this regard, the component mounting operation under discussion is excellent at reducing the component mounting cycle time significantly.

However, as described above, when a component is sucked at the first and second sucking positions K and L, the suction nozzle 20 is displaced upstream or downstream from the reference point C on the arc-shaped travel path of the rotation circle M of the rotary table 11. Consequently, the suction nozzle 20 tends to be positionally deviated with respect to the predetermined position and posture of the component fed from the component supply means 3. This positional deviation, though being a minor error, may cause various problems in fine components, as described previously. That is, in a fine component like the aforesaid 0603 component, even a slight positional deviation causes a suction error, which results in undesirable reduction in the suction rate. As an attempt to prevent this, if the tip of the nozzle is made finer in accordance with the size of the component, the durability is deteriorated and thus the service life is shortened. Another problem is that the component can be damaged by an impact produced when it is brought into abutment with the suction nozzle having a fine tip.

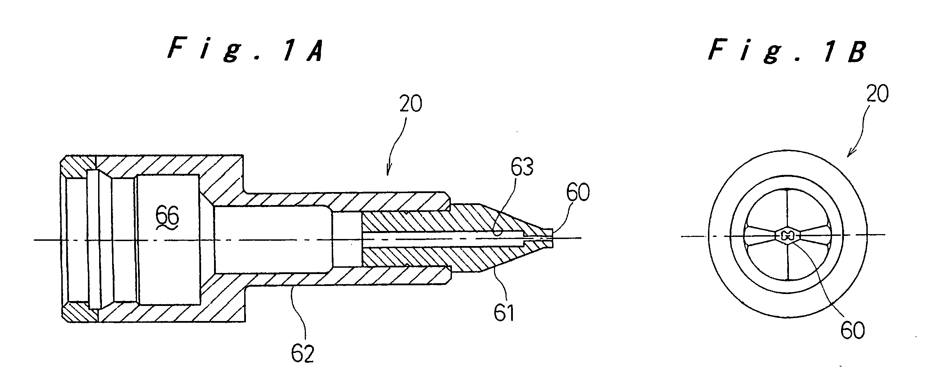

The suction nozzle 20 according to the embodiment has been constructed to solve the above-described problems associated with the sucking operation for fine components, and accordingly, as shown in Figs. 1A and 1B, a sucking surface 60 at the tip of the suction nozzle 20 is so configured as to be fit for a fine component. A tip shaft 61 where the sucking surface 60 is formed is so shaped that its diameter becomes larger gradually toward a base shaft 62 for supporting the tip shaft, whereby making it possible to maintain an adequate strength.

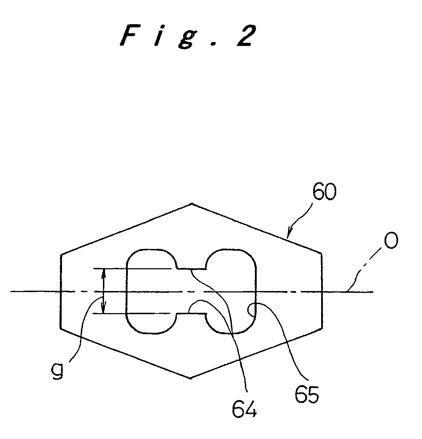

As shown in Fig. 2 under magnification, the sucking surface 60 has a hexagonal configuration like a tortoiseshell pattern and has in its central part a nozzle opening 65. The nozzle opening 65 is brought into communication with a cavity 66 within the base shaft 62 through an air passageway 63 penetrating through the tip shaft 61. In this suction nozzle 20, when attached to the mounting head 12 as shown in Fig. 10, the cavity 66 of the base shaft 62 is connected, through the radial groove 37a, to the air passageway 23 of the mounting head 12. An air suction force is therefore exerted on the nozzle opening 65 of the suction nozzle 20, thereby allowing the sucking surface 60 to suck a component.

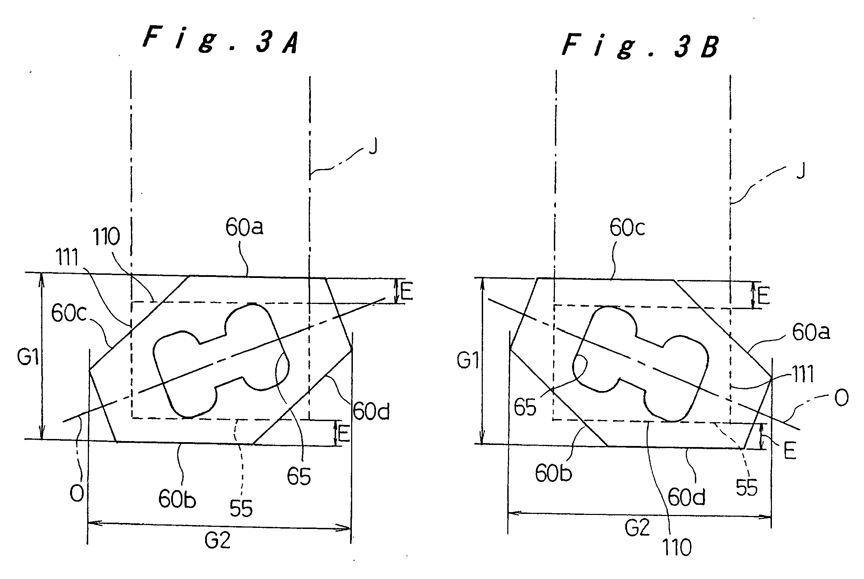

As shown in Figs. 3A and 3B, the suction nozzle 20 is designed to suck a rectangular to-be-sucked surface of a component 55. The nozzle opening 65 is formed as a slot in conformity with the rectangular to-be-sucked surface. Moreover, as shown in Fig. 2, the nozzle opening 65 has in its central part narrowed portions 64, 64 extending on both sides. An interval g between the mutually-opposed narrowed portions 64 is made smaller than the size of a shorter side 111 of the component 55. This helps prevent the component 55 from being sucked into the nozzle opening 65, or being sucked in a stand-up or slanted state.

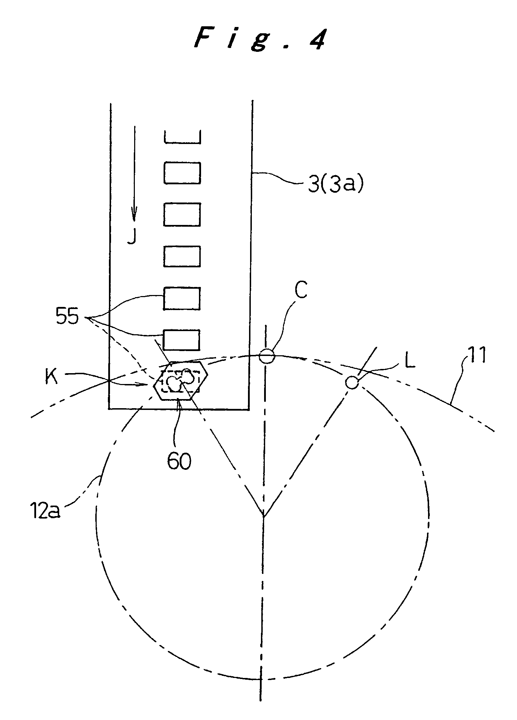

Fig. 3A shows a sucked state of the component 55, in which the suction nozzle 20 is located at the first sucking position K that has been described previously with reference to Figs. 12A through 12E. As shown in Fig. 4 plane-wise, the sucking surface 60 of the suction nozzle 20 is arranged with its central part located in substantially the central part of the to-be-sucked surface of the component 55, and with its longitudinal axis O kept inclined with respect to a component supplying direction J of the component supply means 3a. The sucking surface 60 is so formed that its mutually-opposed sides 60a and 60b are respectively located parallel to a longer side 110 of the component 55, with the longitudinal axis O kept in an inclined state.

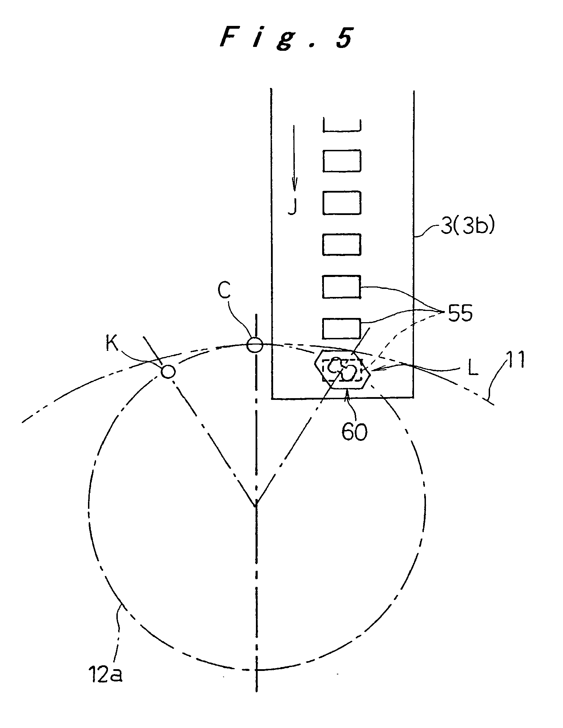

Moreover, Fig. 3B shows another sucked state of the component 55, in which the suction nozzle 20 is located at the second sucking position L that has been described previously with reference to Figs. 12A through 12E. As shown in Fig. 5, the sucking surface 60 is arranged with its longitudinal axis O kept inclined with respect to the component supplying direction J of the component supply means 3b. In the state where the suction nozzle 20 is located at the second sucking position L, the sucking surface 60 is so formed that the mutually-opposed sides 60c and 60d are respectively located parallel to the longer side 110 of the component 55, with the longitudinal axis O kept in an inclined state. The sides 60a to 60d, located parallel to the longer side 110 of the component 55, are each so formed that a portion extending outwardly beyond the longer side 110 of the component 55 (a distance indicated by a symbol E in Figs. 3A and 3B) is made as short as possible to such an extent as to maintain an adequate strength in the suction nozzle 20.

That is, the sucking surface 60 is so formed that a width G1 of the opposed side parallel to a major-axis direction of the component 55 to be sucked, i.e. the longer side 110 of the component 55, is made smaller than a width G2 parallel to a minor-axis direction of the component 55, i.e. the shorter side 111 of the component 55.

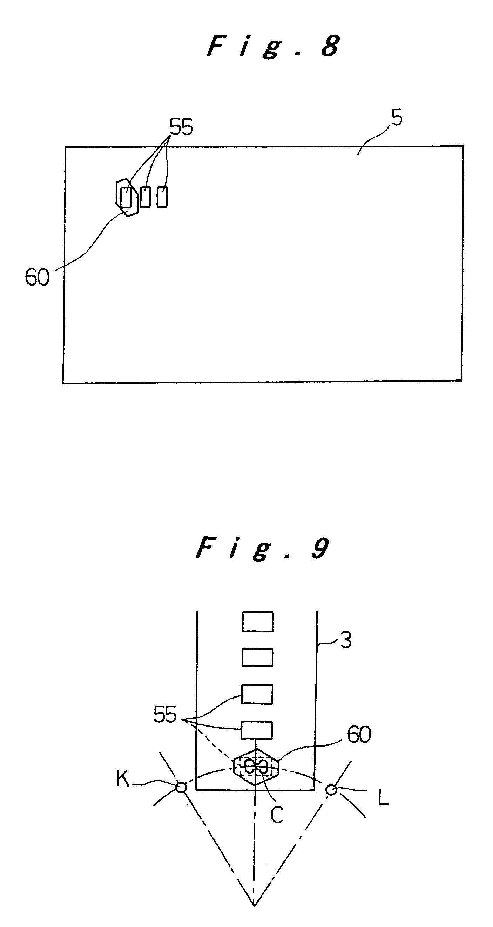

The sucking surface 60 constituted in that way offers the following advantages. As shown in Figs. 4 and 5, when the component 55 is sucked at the first and second sucking positions K and L, the sucking surface 60 is brought into abutment with, out of the components 55 arranged in juxtaposition, only the ones to be sucked, thereby preventing inadvertent interference with the other components 55. Moreover, as shown in Fig. 8, when the sucked component 55 is mounted on a substrate, even if the substrate has a high packaging density, i.e. has such a structure that the components 55 are arranged at small intervals, the mounting is performed successfully. The suction nozzle embodying the present invention, despite being designed to deal with the fine component 55, has such a structure that the sucking surface 60 is made larger in area than the to-be-sucked surface of the component 55. Thus, there is no degradation in the durability. Further, since the sucking surface 60 is made larger in area, the nozzle opening 65 can be opened widely. Thus, the suction force is increased, thereby preventing reduction in the suction rate.

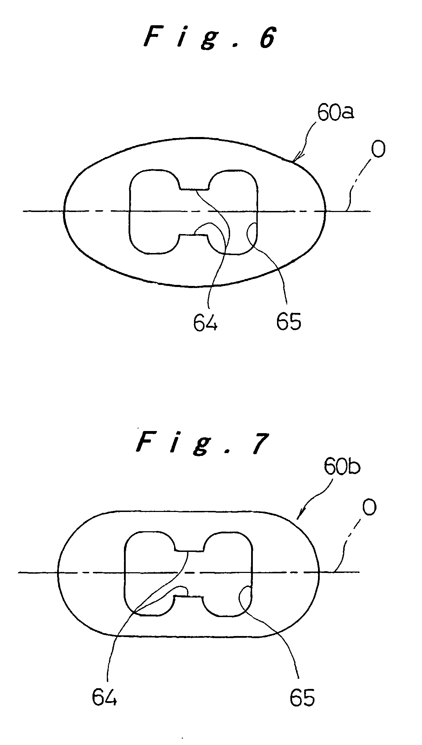

Note that, regarding the contour of the sucking surface 60, even if the sucking surface 60 is formed as an oval-shaped sucking surface 60a as shown in Fig. 6, or as an elongated ellipse-shaped sucking surface 60b as shown in Fig. 7, substantially the same effect as achieved in the above-described tortoiseshell pattern is achieved. Moreover, as shown in Fig. 9, the component 55 may be sucked not only at the first and second sucking positions K and L but also at the reference point C as conventionally practiced.

As described heretofore, according to the present invention, the suction nozzle, despite having a sucking surface made larger in area than the surface to be sucked of the component, is brought into abutment with, out of the components arranged in juxtaposition, only the ones to be sucked during the sucking operation. This helps prevent inadvertent interference with the other components and thus prevent disturbance of the juxtaposed arrangement of the components. Moreover, the components are mounted without any problem in a substrate which has a high packaging density, i.e. has such a structure that the components are arranged at small intervals. Since the sucking surface is made larger in area than the to-be-sucked surface of the component, the suction nozzle no longer has a fine configuration. Consequently, there is no degradation in the durability. Further, the nozzle opening can be opened widely in conformity with the wider area of the sucking surface, thereby increasing the suction force and preventing reduction in the suction rate. Hence, the suction nozzle embodying the present invention offers high serviceability in that, even if a component to be mounted has a fine size, mounting is performed with high accuracy and high suction rate, and that the service life and durability of the nozzle is improved.

## Claims

1. A component mounting method comprising:
successively feeding a plurality of components (55), each having a surface to be sucked, from a component supply portion (2) to a predetermined position; the components being arranged in juxtaposition in a minor-axis direction thereof; and
suckingly holding and mounting on a substrate the components by a suction nozzle (20), the suction nozzle having a sucking surface,
wherein the components are sucked at the predetermined position by the suction nozzle, by the sucking surface abutting on the surface to be sucked, to mount the sucked components on the substrate,
**characterised by**:
the surface to be sucked of each of the components (55) being rectangular and including a longer side (110) and a shorter side (111);
a longitudinal axis (O) of the sucking surface (60) being kept inclined with respect to a direction in which the components are supplied during the holding and mounting of the components; and
the sucking surface being made larger in area than the surface to be sucked, and being configured arbitrarily so long as a width (G1) between mutually-opposed sides, which are parallel to the longer side of the component and are inclined with respect to the longitudinal axis of the sucking surface, is smaller than a width (G2) parallel to the longer side of the component to be sucked.

2. A component mounting method according to claim 1, wherein the longitudinal axis (O) is a longer axis of symmetry of the sucking surface and the sucking surface is inclined such that one or the other end of the longer axis of symmetry approaches the upstream side of the direction in which the components (55) are supplied.

3. A component mounting apparatus comprising:
a component supply portion (2) for successively feeding a plurality of components (55), each having a surface to be sucked, to a supply position, the components being arranged in juxtaposition in a minor-axis direction thereof;
a suction nozzle (20) having a sucking surface (60) for sucking the component by abutting on the surface to be sucked; and
component mounting means for sucking the component at the supply position by way of the suction nozzle and for mounting the sucked component on a substrate by moving the suction nozzle,
**characterised by**:
the surface to be sucked of each of the components (55) being rectangular and including a longer side (110) and a shorter side (111); and
the sucking surface being made larger in area than the surface to be sucked, and being configured arbitrarily so long as a width (G1) between mutually-opposed sides, which are parallel to the longer side of the component and are inclined with respect to a longitudinal axis (O) of the sucking surface, is smaller than a width (G2) parallel to the longer side of the component.

4. A component mounting apparatus according to claim 3, wherein the longitudinal axis (O) is a longer axis of symmetry of the sucking surface, the apparatus being arranged so that the sucking surface is inclined in use such that one or the other end of the longer axis of symmetry approaches the upstream side of the direction in which the components are supplied.

## Patentansprüche

1. Komponentenbefestigungsverfahren mit folgenden Schritten:
sukzessives Zuführen einer Vielzahl vom Komponenten (55), die jeweils eine anzusaugende Oberfläche aufweisen, von einem Komponentenlieferabschnitt (2) zu einer vorbestimmten Position, wobei die Komponenten in Nebeneinanderstellung in einer Nebenachsenrichtung derselben angeordnet sind, und
saugendes Halten und Befestigen der Komponenten auf einem Substrat mittels einer Saugdüse (20), wobei die Saugdüse eine Saugoberfläche aufweist,
wobei die Komponenten an der vorbestimmten Position durch die Saugdüse angesaugt werden, wobei die Saugoberfläche an der anzusaugenden Oberfläche anliegt, um die angesaugten Komponenten auf dem Substrat zu befestigen,
**dadurch gekennzeichnet, dass**:
die anzusaugende Oberfläche von jeder der Komponenten (55) rechtwinklig ist und eine längere Seite (110) und eine kürzere Seite (111) aufweist,
wobei eine longitudinale Achse (0) der Saugoberfläche (60) bezüglich einer Richtung, in der die Komponenten zugeführt werden, während des Haltens und Befestigens der Komponenten schräg gehalten wird, und
wobei die Saugoberfläche flächenmäßig größer ausgebildet ist als die anzusaugende Oberfläche, und wobei die Saugoberfläche beliebig konfiguriert ist, solange eine Weite (G1) zwischen einander gegenüberliegender Seiten, die parallel zu der längeren Seite der Komponente verlaufen und bezüglich der longitudinalen Achse der Saugoberfläche schräg angeordnet sind, kleiner ist als eine Weite (G2) parallel zu der längeren Seite der anzusaugenden Komponente.

2. Komponentenbefestigungsverfahren nach Anspruch 1,
**dadurch gekennzeichnet, dass** die longitudinale Achse (O) eine längere Symmetrieachse der Saugoberfläche ist und dass die Saugoberfläche schräg so angeordnet ist, dass sich das eine oder das andere Ende der längeren Symmetrieachse der Stromaufwärtsseite der Richtung, in der die Komponenten (55) zugeführt werden, annähert.

3. Komponentenbefestigungsvorrichtung mit:
einem Komponentenlieferabschnitt (22) zum sukzessiven Zuführen einer Vielzahl von Komponenten (55), die jeweils eine anzusaugende Oberfläche aufweisen, zu einer Lieferposition, wobei die Komponenten in einer Nebeneinanderstellung in einer Nebenachsenrichtung derselben angeordnet sind,
einer Saugdüse (20) mit einer Saugoberfläche (60) zum Ansaugen der Komponente durch Anliegen an der anzusaugenden Oberfläche, und
Komponentenbefestigungsmittel zum Ansaugen der Komponente an der Lieferposition durch die Saugdüse und zum Befestigen der angesaugten Komponente auf einem Substrat durch Bewegen der Saugdüse,
**dadurch gekennzeichnet, dass**
die anzusaugende Oberfläche von jeder der Komponenten (55) rechtwinklig ist und eine längere Seite (110) und eine kürzere Seite (111) aufweist, und
die Saugoberfläche flächenmäßig größer ausgebildet ist als die anzusaugende Oberfläche und die Saugoberfläche beliebig konfiguriert ist, solange eine Weite (G1) zwischen einander gegenüberliegenden Seiten, die parallel zu der längeren Seite der Komponente verlaufen und bezüglich einer longitudinalen Achse (O) der Saugoberfläche schräg angeordnet ist, kleiner ist als eine Weite (G2) parallel zu der längeren Seite der Komponente.

4. Komponentenbefestigungsvorrichtung nach Anspruch 3,
**dadurch gekennzeichnet, dass** die longitudinale Achse (O) eine längere Symmetrieachse der Saugoberfläche ist, wobei die Vorrichtung so angeordnet ist, dass die Saugoberfläche im Gebrauch schräg ist, so dass sich das eine oder das andere Ende der längeren Symmetrieachse der Stromaufwärtsseite der Richtung, in der die Komponenten zugeführt werden, annähert.

## Revendications

1. Procédé de montage de composants comprenant les étapes consistant à :
amener successivement plusieurs composants (55), ayant chacun une surface destinée à être aspirée, depuis une partie (2) d'alimentation de composants jusqu'à une position prédéterminée ; les composants étant disposés en juxtaposition dans une direction de leur petit axe ; et
maintenir par aspiration et monter les composants sur un substrat par une buse d'aspiration (20), la buse d'aspiration disposant d'une surface d'aspiration,
dans lequel les composants sont aspirés à la position prédéterminée par la buse d'aspiration, la surface d'aspiration s'appuyant contre la surface à aspirer, pour monter les composants aspirés sur le substrat,
**caractérisé par le fait que** :
la surface à aspirer de chacun des composants (55) est rectangulaire et comprend un côté plus long (110) et un côté plus court (111) ;
un axe longitudinal (O) de la surface d'aspiration (60) est tenu incliné par rapport à une direction dans laquelle les composants sont amenés pendant le maintien et le montage des composants ; et
la surface d'aspiration étant faite plus grande en surface que la surface à aspirer, et étant configurée arbitrairement aussi longue qu'une largeur (G1) entre des côtés opposés l'un à l'autre, qui sont parallèles au côté plus long du composant et sont inclinés par rapport à l'axe longitudinal de la surface d'aspiration, est plus petite qu'une largeur (G2) parallèle au côté plus long du composant à aspirer.

2. Procédé de montage de composants selon la revendication 1, dans lequel l'axe longitudinal (O) est un axe plus long de symétrie de la surface d'aspiration et la surface d'aspiration est inclinée de telle sorte que l'une ou l'autre extrémité de l'axe plus long de symétrie s'approche du côté amont de la direction dans laquelle les composants (55) sont amenés.

3. Dispositif de montage de composants comprenant :
une partie (2) d'alimentation de composants destinée à amener successivement plusieurs composants (55), ayant chacun une surface destinée à être aspirée, jusqu'à une position d'alimentation, les composants étant disposés en juxtaposition dans une direction de leur petit axe ;
une buse d'aspiration (20) disposant d'une surface d'aspiration (60) destinée à aspirer le composant en s'appuyant contre la surface à aspirer ; et
un moyen de montage des composants destiné à aspirer le composant à la position d'alimentation au moyen de la buse d'aspiration et à monter le composant aspiré sur un substrat en déplaçant la buse d'aspiration,
**caractérisé par le fait que** :
la surface à aspirer de chacun des composants (55) est rectangulaire et comprend un côté plus long (110) et un côté plus court (111) ; et
la surface d'aspiration étant faite plus grande en surface que la surface à aspirer, et étant configurée arbitrairement aussi longue qu'une largeur (G1) entre des côtés opposés l'un à l'autre, qui sont parallèles au côté plus long du composant et sont inclinés par rapport à un axe longitudinal (0) de la surface d'aspiration, est plus petite qu'une largeur (G2) parallèle au côté plus long du composant.

4. Dispositif de montage de composants selon la revendication 3, dans lequel l'axe longitudinal (0) est un axe plus long de symétrie de la surface d'aspiration, le dispositif étant organisé de manière telle que la surface d'aspiration soit inclinée en utilisation de telle sorte que l'une ou l'autre extrémité de l'axe plus long de symétrie s'approche du côté amont de la direction dans laquelle les composants sont amenés.
